(19) Europäisches Patentamt
European Patent Office
Office européen des brevets

(11) EP 3 731 614 B1

(12) EUROPEAN PATENT SPECIFICATION

(45) Date of publication and mention
of the grant of the patent:
09.08.2023 Bulletin 2023/32

(51) International Patent Classification (IPC):
H05K 9/00 (2006.01)         H01F 1/11 (2006.01)
H01F 41/02 (2006.01)

(21) Application number: 18891103.6

(22) Date of filing: 19.12.2018

(52) Cooperative Patent Classification (CPC):
H05K 9/0073; H01F 1/16; H01F 3/02; H01F 27/366;
H01F 41/0233; H05K 9/0075

(86) International application number:
PCT/KR2018/016260

(87) International publication number:
WO 2019/124982 (27.06.2019 Gazette 2019/26)

(54) **STEEL SHEET FOR SHIELDING MAGNETIC FIELD AND METHOD FOR MANUFACTURING SAME**

STAHLBLECH ZUR ABSCHIRMUNG EINES MAGNETFELDES UND VERFAHREN ZU DESSEN HERSTELLUNG

TÔLE D'ACIER POUR BLINDAGE CONTRE UN CHAMP MAGNÉTIQUE ET SON PROCÉDÉ DE FABRICATION

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 22.12.2017 KR 20170178864

(43) Date of publication of application:
28.10.2020 Bulletin 2020/44

(73) Proprietor: POSCO Co., Ltd
Pohang-si, Gyeongsangbuk-do 37859 (KR)

(72) Inventors:
• SO, Tae-Il
  Gwangyang-si Jeollanam-do 57807 (KR)
• SHIM, Ho-Kyung
  Incheon 21985 (KR)
• KIM, Chon-Kue
  Seoul 06194 (KR)
• CHOI, Jong-In
  Seoul 06194 (KR)

(74) Representative: Potter Clarkson
Chapel Quarter
Mount Street
Nottingham NG1 6HQ (GB)

(56) References cited:
JP-A- 2007 016 278        JP-A- 2008 308 704
JP-A- 2013 227 649        JP-A- 2013 227 649
KR-A- 20040 041 454       KR-A- 20120 020 478
KR-B1- 100 638 043        KR-B1- 101 359 109

**Description**

**[Technical Field]**

The present disclosure relates to a steel sheet for shielding a magnetic field used in a medical magnetic resonance imaging (MRI) room wall, or the like, and a method for manufacturing the same.

**[Background Art]**

A magnetic resonance imaging (MRI) device mainly used in hospitals is a device applying radio waves to a human body located within a strong magnetic field and measuring the reflected magnetic field to observe brains, internal organs, and other internal organs. The MRI device utilizes a superconducting magnet to generate a static magnetic field, and there have recently been high magnetic field MRI devices of 7 T (T: Tesla) or higher developed to obtain high-resolution images.

When a leakage magnetic field occurs outside an MRI room due to a high magnetic field generated from the MRI device, malfunctioning of electronic equipment is caused by disturbing a signal system of a high-precision electronic device. Further, as there have been studies undertaken to show a high magnetic field has a detrimental effect on the human body, it is necessary to use a magnetic shielding material to prevent such high magnetic field from leaking to the outside. More preferably, a magnetic shielding material, which has high performance and is economical, is required. In this regard, it is essential to select an optimal shielding material and thickness such that a magnetic flux density outside a conventional MRI shielding room is less than 5 Gauss (=0.5 mT).

In particular, permeability characteristics indicating a high magnetic flux density according to a specific magnetic field intensity in a material are important in shielding a DC magnetic field, and it is necessary to have a low coercive force. In order to decrease coercive force while increasing permeability, precipitates such as carbon, nitrogen, carbides or nitrides in steel, which hinder movements of a magnetic domain wall, should be minimized, and grain growth should be promoted while reducing grain boundaries. An addition of impurities to steel forms finely dispersed precipitates during solidification or during a heat treatment process after rolling, thereby forming a new magnetic domain which reduces static magnetic energy and intervenes movements of the magnetic domain wall. In addition, when impurities enter iron as an intrusion type rather than a substitution type, a greater adverse effect is imposed on magnetic characteristics. The intrusive element reduces permeability by elastically deforming a lattice of a solid solution, and carbon is a representative element.

Patent Document 1 has proposed a hot-rolled pickled thick steel sheet having excellent magnetic field shielding characteristics; however, the steel sheet of Patent Document 1 is different from that of the present disclosure in that it lacks magnetic shielding performance because magnetic characteristics are only provided by hot-rolling, coiling and pickling without a heat treatment and is a material for shielding an AC magnetic fields. Recently, there is increasing demand for steel materials having excellent magnetic shielding ability capable of shielding a DC magnetic field such as an MRI room.

Patent Document 2 relates to the iron core of a reluctance motor and proposes a cold-rolled steel sheet that can further increase output torque and maximum rotation speed. However, due to the characteristics of a cold-rolled steel sheet, there is a limit to coarsening the grains due to the high rolling reduction. In addition, there is a disadvantage that the self-shielding performance may be insufficient in terms of the internal stress of the steel sheet when performing tension levelling or skin pass rolling. Patent Documents 3 and 4 relate to non-oriented electrical steel sheets for rotors, and due to the formation of precipitates due to the addition of alloying elements such as Si, Mn, Al, Nb, Ti, Zr, V, Mo, Co, W, there is a disadvantage in that the magnetic shielding performance may be limited.

(Patent Document 1) Korea Patent Publication No. 10-2005-0129244

(Patent Document 2) Japan Patent Publication No. 2013-227649

(Patent Document 3) Japan Patent Publication No. 2007-016278

(Patent Document 4) Japan Patent Publication No. 2008-308704

**[Disclosure]**

**[Technical Problem]**

An aspect of the present disclosure is to provide a steel sheet having excellent magnetic field shielding performance by controlling alloying elements and heat treatment conditions, and a method for manufacturing the same.

A technical problem of the present disclosure is not limited thereto, and other problems not mentioned will be clearly understood by those skilled in the art from the following description.

**[Technical Solution]**

An aspect of the present disclosure relates to a steel sheet according to claim 1.

An another aspect relates to a method for manufacturing a steel sheet according to claim 5.

**[Advantageous Effects]**

The present disclosure can provide a steel sheet having excellent magnetic field shielding performance, capable of suppressing an impact on the human body and external electronic devices when applying a DC magnetic field and applying the DC magnetic field from an MRI device to outside of an MRI room by enabling smooth movements of magnetic domains.

**[Brief Description of Drawings]**

FIG. 1 is a graph illustrating magnetic flux density according to magnetic field intensity of Inventive Examples 2, 5 and 7 and Comparative Example 2.

FIG. 2 is a graph illustrating relative permeability according to the magnetic flux density of Inventive Examples 2, 5 and 7 and Comparative Example 2.

**[Best Mode for Invention]**

The present inventors conducted extensive research on the above technical problems, and as a result, controlled alloying elements and a manufacturing process to improve shielding performance of a DC magnetic field to coarse grains and facilitate smooth movements of a magnetic domain when the DC magnetic field is applied, thereby providing a steel material having a size of 15 mmt capable of preventing the DC magnetic field released from hospital MRI devices being applied to the outside an MRI room and affecting the human body and external electronic devices.

First, a composition range of the steel sheet of the present disclosure is described. The steel sheet of the present disclosure may contain, by weight% (hereinafter, "%"), 0.02% or less of carbon (C), 0.001% to 0.05% of silicon (Si), 0.01% to 0.2% of manganese (Mn), 0.001% or 0.05% of aluminum (Al), 0.005% or less of niobium (Nb), 0.07% or less of titanium (Ti), 0.01% or less of nitrogen (N), 0.015% or less of phosphorus (P), 0.005% or less of sulfur (S), and a remainder of iron (Fe) and inevitable impurities.

C: 0.02% or less

Carbon (C) significantly reduces permeability by elastically deforming a lattice of a solid solution. In addition, as ferrite or carbide formed due to C interferes a movement of a magnetic domain wall so that increases an iron loss, it is preferable not to contain carbon as little as possible. Accordingly, C is preferably contained of 0.02% or less, more preferably 0.005% or less.

Si: 0.001% to 0.05%

Silicon (Si) is mainly used as a deoxidizer. When Si is contained, solubility of C is reduced, thereby lowering magnetic field shielding characteristics. In this regard, it is preferable to contain 0.05% or less. However, Si less than 0.001% results in insufficient deoxidization. Accordingly, an amount of Si is preferably 0.001% to 0.05%, more preferably 0.001% to 0.05%.

Mn: 0.01% to 0.2%

Manganese (Mn) is an element binding to S to form MnS, which is a factor itself increasing brittleness. In order to reduce the brittleness due to S, it is preferable to contain 0.01% or more. However, since MnS formed at a grain boundary during high temperature heat treatment suppress grain coarsening, it is preferable that an amount of Mn not exceed 0.2%.

Al: 0.001% to 0.05%

Aluminum (Al) is an element for deoxidizing molten steel inexpensively. To sufficiently obtain such an effect, it is preferable to contain 0.001% or more. In the case of an amount exceeding 0.05%, however, Al binds to N to form AlN, thereby suppressing grain coarsening. In this regard, it is preferable to contain Al in an amount of 0.05% or less.

Nb: 0.005% or less

Niobium (Nb) is an element precipitated in the form of NbC or Nb(C,N) to significantly improve strength of a base material and a weld zone. Further, Nb employed during reheating at a high temperature suppresses recrystallization of austenite and transformation of ferrite or bainite thereby refine a structure. In this regard, Nb is an element added to secure strength of a conventional hot rolled steel sheet. Meanwhile, Nb has an adverse effect on magnetic shielding characteristics due to grain refinement, and thus, it is preferable that 0.005% or less of Nb be contained.

Ti: 0.07% or less

Titanium (Ti) has an effect of inhibiting grain growth as a result of reacting mainly with nitrogen when heated and thus is preferable to be added to a conventional carbon steel to improve strength and toughness. In the present disclosure, however, not only strength and toughness are not important factors but also Ti is a detrimental element in grain coarsening, it is preferable to contain Ti in an amount of 0.07% or less.

N: 0.01% (100 ppm) or less

Nitrogen (N) is an element forming TiN when simultaneously added with Ti and forming AlN by binding to Al when Ti is not added. In the case in which TiN, AlN, or the like, is formed at a grain boundary or within a grain, grain coarsening is suppressed during heat treatment at a high temperature. Accordingly, N is preferably contained in an amount of 0.01% (100 ppm) or less, more preferably 0.005% (50 ppm) or less.

P: 0.015% or less

Phosphorus (P) is an element advantageous in improving strength and corrosion resistance but may significantly increase brittleness of a material. In this regard, it is desirable that an amount thereof be managed to be as low as possible. Accordingly, it is preferable that the amount of P be 0.015% or less.

S: 0.005% or less

Sulfur (S) is an element, which significantly increases brittleness by forming MnS, or the like, and thus is desirable to manage an amount as low as possible. Accordingly, it is preferable that an amount of S be 0.005% or less.

The steel sheet of the present disclosure contains iron (Fe) in addition to the above mentioned alloy elements. However, undesired impurities may be inevitably incorporated from an environment or a raw material during a conventional manufacturing process and thus cannot be excluded. Such impurities are known to any one of ordinary skill in the art, and will thus not be mentioned in detail.

The steel sheet of the present disclosure has a main structure of ferrite and preferably contains 95 area% or more of ferrite, more preferably 99 area% or more.

The average grain size of the ferrite is 100 um or greater. In the case in which the grain size is less than 100 um after hot rolling, air cooling, normalizing heat treatment, and stress relief annealing, a movement of a magnetic domain is not smooth so that a magnetic flux density is not sufficiently high when a magnetic field is induced on a shielding steel sheet. Thereby, a shielding effect is not sufficient when a DC magnetic field is applied to an MRI of 7 T or higher.

Meanwhile, the steel sheet of the present disclosure may contain precipitates at a grain boundary or within a grain of the ferrite. The precipitates may be AlN, TiN, MnS, or the like. As the precipitates serve to suppress grain growth due to a pinning effect during the normalizing heat treatment after rolling, it is preferable that a maximum size of the precipitate not exceed 100 nm, more preferably 20 nm.

It is preferable that the steel sheet has yield strength of 190 MPa or less, tensile strength of 220 MPa to 300 MPa, elongation of 40% or more, and a yield ratio of 0.8 or less.

In the case of high magnetic field MRI equipment of 7 T or higher, magnetic field intensity of a DC magnetic field induced on a shielding steel sheet forming an MRI room wall body is conventionally 200 A/m to 300 A/m and is commonly designed to be applied with a magnetic flux density of 1.3 T to 1.5 T. Accordingly, the steel sheet of the present disclosure preferably has a magnetic flux density of 1 T(Tesla) or higher under magnetic field intensity of 300 A/m, more preferably 1.3 T or higher for better DC magnetic field shielding performance.

A method for manufacturing the steel sheet of the present disclosure will be described in detail. The steel sheet of the present disclosure may be manufactured by heating a steel material (a steel slab) satisfying the alloy composition described above and hot rolling. If necessary, stress relief annealing may be performed, in addition to a normalizing heat treatment. Each process will be described in detail.

As an example, a steel material satisfying the previously described alloy composition, a steel slab, is prepared and heated. The heating is preferably performed in the temperature range of Ac3 to 1250°C. The Ac3 can be calculated using Equation 1 below. When the heating temperature of the steel slab is less than Ac3, transformation of austenite to ferrite is initiated during rolling, thereby adversely affecting magnetic characteristics due to refinement of grain size of ferrite. Meanwhile, it is preferable that the heating be performed at a temperature not exceeding 1250°C in consideration of economical feasibility.

[Equation 1]

$$Ac3(°C) = 937.2 - 436.5C + 56Si - 19.7Mn + 136.3Ti - 19.1Nb + 198.4Al$$

Each component symbol refers to a content thereof (wt%). The heated steel material is hot rolled. The hot rolling process specifically involves rough rolling of the reheated slab and finish rolling to obtain a hot rolled steel sheet. The rough rolling is preferably performed in the temperature range of Tnr to 1250°C. When the slab is rolled at a temperature below Tnr, grains are refined, thereby making it ineffective in improving magnetic shielding performance. Meanwhile, the Tnr can be derived from Equation 2 below.

[Equation 2]

$$Tnr(°C) = 887 + 464C + (6445Nb - /644Nb) + 890Ti + 363Al - 357Si$$

Each component symbol refers to a content thereof (wt%) .

Meanwhile, when the finish rolling is performed in a temperature range below Ar3 , at which the austenite begins to transform to ferrite, refined ferrite forms nuclei at a ferrite grain boundary, thereby reducing an average grain size adversely affecting magnetic characteristics. Accordingly, it is preferable that the finish rolling be performed at a temperature of Ar3 or higher.

Hot rolled steel sheet is then cooled. The cooling is not particularly managed. As a preferred example, air cooling is performed, the air cooling is performed until the temperature reaches room temperature.

The cooled steel sheet is normalizing heat treated of maintaining at a temperature of Ac3 or higher for (1.3t+30) minutes, and then, furnace cooling or air cooling. The normalizing heat treatment performed for a long period of time at a temperature of Ar3 or higher is effective in improving magnetic shielding characteristics due to additional grain coarsening. It requires at least (1.3t, t: thickness) minutes to allow an thick steel plate to reach a target temperature, and at least 30 minutes of maintaining after the target temperature is reached to distribute a uniform temperature from a surface of the steel sheet to a center thereof.

To remove stress inside the steel sheet which has been normalizing heat treated, stress relief annealing of heat treating at 800°C to 900°C for (1.3t+30) minutes, and then, furnace cooling may be performed. Stress remaining in the hot rolled steel sheet, which has been rough rolled and finish rolled, may interfere movements of the magnetic domain and significantly reduce the magnetic characteristics. In this regard, stress relief annealing of heat treating at 800°C to 900°C for (1.3t+30, t: thickness of steel sheet) minutes after the normalizing heat treatment, and then air cooling or furnace cooling, may be additionally performed to maximize the magnetic shielding characteristics.

**[Mode for Invention]**

The prevent disclosure will be described in more detail with reference to the Examples. The Examples, however, are merely for understanding of the present disclosure and should not be construed as limiting the present disclosure. The scope of the present disclosure is determined by subject matter described in the claims and reasonably inferred therefrom.

(Examples)

A steel slab having a thickness of 300 mm and the composition of Table 1 is prepared, and a sheet material is manufactured under the condition of Table 2 below. A unit of the alloy composition of Table 1 is wt%, and a remainder of iron (Fe) and inevitable impurities are included.

[Table 1]

| classi ficati on | C | Si | Mn | P | S | T-Al | Nb | Ti | N |
|---|---|---|---|---|---|---|---|---|---|
| Steel 1 | 0.0015 | 0.002 | 0.053 | 0.0070 | 0.0038 | 0.0322 | 0.0014 | 0.0686 | 0.0022 |
| Steel 2 | 0.0195 | 0.001 | 0.195 | 0.0072 | 0.0032 | 0.0230 | 0.0001 | 0.0001 | 0.0018 |
| Steel 3 | 0.0016 | 0.003 | 0.032 | 0.0057 | 0.0045 | 0.0076 | 0.0005 | 0.0003 | 0.0019 |
| Steel 4 | 0.1500 | 0.010 | 0.500 | 0.0150 | 0.0150 | 0.0400 | 0.0001 | 0.0001 | - |
| Steel 5 | 0.0300 | 0.010 | 0.200 | 0.0100 | 0.0100 | 0.035 | 0.0001 | 0.0001 | - |
| Steel 6 | 0.0015 | 0.002 | 0.069 | 0.0092 | 0.0043 | 0.035 | 0.0001 | 0.0289 | 0.0095 |

[Table 2]

| Steel | Slab heating temp (°C) | Finish rolling temp (°C) | Thickne ss (mm) | Normali zing heat treatme nt temp (°C) | Normali zing heat treatme nt time (min) | Cooling after Normali zing heat treatme nt | Stress relief anneali ng temp (°C) | Stress relief time (min) | note |
|---|---|---|---|---|---|---|---|---|---|
| Steel 1 | 1180 | 980 | 25 | 950 | 62.5 | air cooling | - | - | IE 1 |
| Steel 1 | 1180 | 980 | 25 | 950 | 62.5 | furnace cooling | - | - | IE 2 |
| Steel 1 | 1180 | 980 | 25 | - | - | - | - | - | IE 3 |
| Steel 2 | 1180 | 980 | 25 | 950 | 62.5 | air cooling | - | - | IE 4 |
| Steel 2 | 1180 | 980 | 25 | 950 | 62.5 | furnace cooling | - | - | IE 5 |
| Steel 3 | 1140 | 920 | 25 | 910 | 100 | air cooling | - | - | IE 6 |
| Steel 3 | 1140 | 920 | 25 | 910 | 100 | air cooling | 840 | 120 | IE 7 |
| Steel 4 | 1180 | 860 | 25 | - | - | - | - | - | CE 1 |
| Steel 5 | 1180 | 890 | 20 | - | - | - | - | - | CE 2 |
| Steel 6 | 1180 | 920 | 2.5 | - | - | - | - | - | CE 3 |
| *IE: Inventive Example **CE: Comparative Example | | | | | | | | | |

For the steel sheet manufactured under the conditions of Table 2, a grain size and mechanical properties were evaluated and indicated in Table 3 below. The grain size was observed in a thickness direction of the steel sheet using an optical microscope. Meanwhile, the mechanical properties, such as yield strength, tensile strength, elongation, and the like, were evaluated using a tensile tester by taking a full thickness sample in a rolling direction at room temperature.

[Table 3]

| classification | Grain size (μm) | Yield strength (MPa) | Tensile strength (MPa) | Elongation (%) | Yield ratio |
|---|---|---|---|---|---|
| IE 1 | 357.0 | 102 | 258 | 76.8 | 0.40 |
| IE 2 | 386.0 | 86 | 253 | 77.3 | 0.34 |
| IE 3 | 121.5 | 113 | 263 | 76.4 | 0.43 |
| IE 4 | 320.5 | 180 | 289 | 65.8 | 0.63 |
| IE 5 | 345.5 | 172 | 281 | 70.2 | 0.61 |
| IE 6 | 137.1 | 149 | 270 | 66.0 | 0.62 |
| IE 7 | 168.3 | 120 | 265 | 71.5 | 0.45 |
| CE 1 | 21.1 | 232 | 409 | 42.1 | 0.57 |
| CE 2 | 22.4 | 194 | 304 | 44.1 | 0.61 |
| CE 3 | 35.2 | 204 | 272 | 40.2 | 0.75 |
| *IE: Inventive Example **CE: Comparative Example | | | | | |

As shown in Table 3, Inventive Examples satisfying the alloy composition and manufacturing process of the present disclosure have a grain size of 100 um or greater, yield strength of 190 MPa or less, tensile strength of 220 MPa to 300 MPa, elongation of 40% or more, and a yield ratio of 0.8 or less.

Meanwhile, in the case of Inventive Example 3, the same composition as and similar manufacturing processes of Inventive Examples 1 and 2 are applied, however, a normalizing heat treatment was not performed. Thereby, the grain size of Inventive Example 3 is relatively small as compared to Inventive Examples 1 and 2.

Meanwhile, Comparative Examples 1 and 2 employs a steel containing C in an amount exceeding the amount suggested in the present disclosure, so that they contain grains having a refined size as compared to those of Inventive Examples 1 to 7, and thus have yield strength and tensile strength beyond the ranges suggested in the present disclosure due to grain refinement. Comparative Example 3 has a composition satisfying the range suggested in the present disclosure, however, a thickness of a final product after hot rolling the slab is small (a total reduction amount is increased), which is beyond the strength range suggested in the present disclosure.

Meanwhile, a magnetic flux density of the manufactured steel sheet was measured with respect to magnetic field intensity and indicated in Table 4 below.

[Table 4]

| classification | Magnetic flux density to magnetic field intensity (T) | | | |
|---|---|---|---|---|
| | B2 (200A/m) | B3 (300A/m) | B5 (500A/m) | B25 (2500A/m) |
| IE 1 | 1.14 | 1.36 | 1.50 | 1.66 |
| IE 2 | 1.33 | 1.44 | 1.51 | 1.65 |
| IE 3 | 0.88 | 1.11 | 1.34 | 1.65 |
| IE 4 | 0.74 | 1.04 | 1.32 | 1.64 |
| IE 5 | 0.78 | 1.16 | 1.44 | 1.66 |
| IE 6 | 1.03 | 1.23 | 1.38 | 1.64 |
| IE 7 | 1.41 | 1.48 | 1.54 | 1.65 |
| CE 1 | 0.02 | 0.11 | 0.36 | 1.55 |
| CE 2 | 0.22 | 0.52 | 0.86 | 1.63 |
| CE 3 | 0.74 | 0.98 | 1.34 | 1.59 |
| *IE: Inventive Example **CE: Comparative Example | | | | |

As indicated in Table 4 above, Inventive Examples 1 to 7 satisfying the alloy composition and manufacturing method of the present disclosure have a magnetic flux density of 1.0 T or higher at magnetic field intensity of B3.

Meanwhile, Inventive Example 3, among all Inventive Examples, does not involve additional normalizing heat treatment after hot rolling and cooling and showed relative lower values as compared to Inventive Examples 1 and 2, which are in similar conditions. In contrast, Inventive Example 7 is a result of performing stress relief annealing and thus has a highest excellent magnetic flux density compared to the other conditions.

Meanwhile, Comparative Examples 1 to 3 have a magnetic flux density of 0.11 T to 0.98 T at magnetic field intensity of B3, indicating inappropriateness to be used as a material for an MRI shielding room of 7 T or higher.

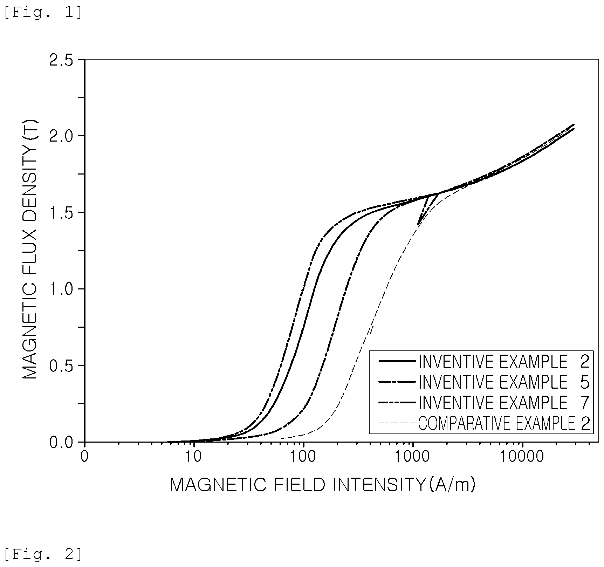

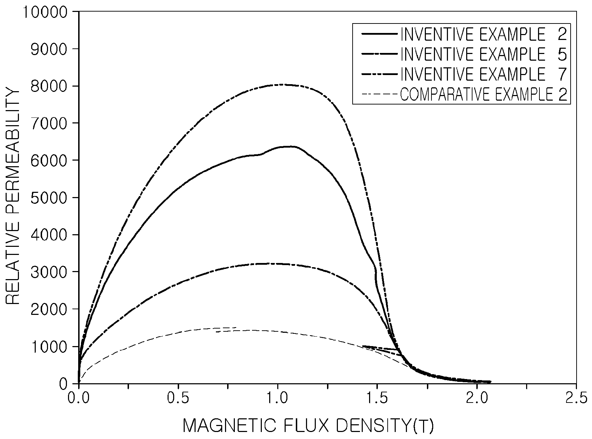

FIG. 1 is a graph illustrating magnetic flux density according to magnetic field intensity of Inventive Examples 2, 5 and 7 and Comparative Example 2. In a certain magnetic field intensity region, the magnetic flux density was found to be high in the order of Examples 7, 2, and 5, while Comparative Example 2 showed a lowest magnetic flux density. It can be seen that the magnetic characteristics are the highest when the stress relief annealing and normalizing heat treatment are performed after hot rolling and the composition and components suggested in the present disclosure are satisfied.

FIG. 2 is a graph illustrating relative permeability according to the magnetic flux density of Inventive Examples 2, 5 and 7 and Comparative Example 2. Permeability is a value indicating a degree of magnetization of a medium in a given magnetic field, while relative permeability indicates a ratio of permeability of a medium to vacuum permeability and is represented as the equation "magnetic flux density/magnetic field intensity/1.257." The relative permeability of FIG. 2 illustrates a result of each sample indicated in FIG. 1 calculated using the equation with respect to the magnetic flux density. The graph indicates that a higher relative magnetic permeability enables easier magnetization of a shielding material when a magnetic field is applied and more effective shielding performance.

**Claims**

1.  A steel sheet for shielding a magnetic field, comprising:

    by weight%, 0.02% or less of carbon (C), 0.001% to 0.05% of silicon (Si), 0.01% to 0.2% of manganese (Mn), 0.001% or 0.05% of aluminum (Al), 0.005% or less niobium (Nb), 0.07% or less of titanium (Ti), 0.01% or less of nitrogen (N), 0.015% or less of phosphorus (P), 0.005% or less of sulfur (S), and a remainder of iron (Fe) and inevitable impurities,
    wherein a microstructure has ferrite as a main structure, wherein the ferrite has an average grain size of 100 um or greater.

2.  The steel sheet for shielding a magnetic field of claim 1,
    wherein the steel sheet has a maximum size of a precipitate, existing at a boundary of or within the ferrite grain, is 100 nm or less.

3.  The steel sheet for shielding a magnetic field of claim 1,
    wherein the steel sheet has a magnetic flux density of 1 T (Tesla) or higher under a magnetic field intensity of 300 A/m.

4.  The steel sheet for shielding a magnetic field of claim 1,
    wherein steel sheet has yield strength of 190 MPa or less, tensile strength of 220 MPa to 300 MPa, elongation of 40% or more, and a yield ratio of 0.8 or less.

5.  A method for manufacturing a steel sheet for shielding a magnetic field, comprising:

    reheating a steel slab comprising by weight%, 0.02% or less of carbon (C), 0.001% to 0.05% of silicon (Si), 0.01% to 0.2% of manganese (Mn), 0.001% or 0.05% of aluminum (Al), 0.005% or less niobium (Nb), 0.07% or less of titanium (Ti), 0.01% or less of nitrogen (N), 0.015% or less of phosphorus (P), 0.005% or less of sulfur (S), and a remainder of iron (Fe) and inevitable impurities at a temperature of Ac3 to 1250°C;
    hot rolling the reheated slab and finish hot rolling at a temperature of Ar3 or higher to obtain the steel sheet; and
    air cooling the steel sheet to room temperature, such that a microstructure has ferrite as a main structure, wherein the ferrite has an average grain size of $100 \mu m$ or greater.

6.  The method for manufacturing a steel sheet for shielding a magnetic field of claim 5, further comprising normalizing heat treatment of maintaining at a temperature of Ar3 or higher for at least 1.3t+30 minutes, where t is the thickness of the steel sheet in mm, and then, of furnace cooling or air cooling.

7. The method for manufacturing a steel sheet for shielding a magnetic field of claim 6, further comprising stress relief annealing of heat treating at a temperature of 800°C to 900°C for at least 1.3t+30 minutes after the normalizing heat treatment, and then, of furnace cooling.

8. The method for manufacturing a steel sheet for shielding a magnetic field of claim 5, wherein, during the hot rolling, rough rolling is performed at a temperature of Tnr to 1250°C before the finish hot rolling.

**Patentansprüche**

1. Stahlblech zum Abschirmen eines Magnetfeldes, das Folgendes umfasst:
   in Gewichtsprozent, 0,02 % oder weniger Kohlenstoff (C), 0,001 % bis 0,05 % Silizium (Si), 0,01 % bis 0,2 % Mangan (Mn), 0,001 % oder 0,05 % Aluminium (Al), 0,005 % oder weniger Niob (Nb), 0,07 % oder weniger Titan (Ti), 0,01 % oder weniger Stickstoff (N), 0,015 % oder weniger Phosphor (P), 0,005 % oder weniger Schwefel (S), und einen Rest Eisen (Fe) und unvermeidbare Verunreinigungen, wobei eine Mikrostruktur Ferrit als Hauptstruktur aufweist, wobei der Ferrit eine durchschnittliche Korngröße von 100 $\mu$m oder mehr aufweist.

2. Stahlblech zum Abschirmen eines Magnetfeldes nach Anspruch 1, wobei das Stahlblech eine maximale Größe einer Fällung, die an einer Grenze des Ferritkorns oder innerhalb des Ferritkorns vorliegt, von 100 nm oder weniger aufweist.

3. Stahlblech zum Abschirmen eines Magnetfeldes nach Anspruch 1, wobei das Stahlblech eine magnetische Flussdichte von 1 T (Tesla) oder höher bei einer magnetische Feldstärke von 300 A/m aufweist.

4. Stahlblech zum Abschirmen eines Magnetfeldes nach Anspruch 1,
   wobei das Stahlblech eine Streckgrenze von 190 MPa oder weniger, eine Zugfestigkeit von 220 MPa bis 300 MPa, eine Dehnung von 40 % oder mehr und ein Streckgrenzenverhältnis von 0,8 oder weniger aufweist.

5. Verfahren zur Fertigung eines Stahlblechs zum Abschirmen eines Magnetfeldes, das Folgendes umfasst:

   Wiedererhitzen einer Stahlbramme, die in Gewichtsprozent 0,02 % oder weniger Kohlenstoff (C), 0,001 % bis 0,05 % Silizium (Si), 0,01 % bis 0,2 = Mangan (Mn), 0,001 % oder 0,05 % Aluminium (Al), 0,005 % oder weniger Niob (Nb), 0,07 % oder weniger Titan (Ti), 0,01 % oder weniger Stickstoff (N), 0,015 % oder weniger Phosphor (P), 0,005 % oder weniger Schwefel (S), und einen Rest Eisen (Fe) und unvermeidbare Verunreinigungen bei einer Temperatur von Ac3 bis 1250 °C umfasst;
   Warmwalzen der wiedererhitzten Bramme und Fertigwarmwalzen bei einer Temperatur von Ar3 oder höher, um das Stahlblech zu erhalten; und
   Luftkühlen des Stahlblechs auf Raumtemperatur, sodass eine Mikrostruktur Ferrit als Hauptstruktur aufweist, wobei der Ferrit eine durchschnittliche Korngröße von 100 $\mu$m oder mehr aufweist.

6. Verfahren zur Fertigung eines Stahlblechs zum Abschirmen eines Magnetfeldes nach Anspruch 5, das ferner eine normalisierende Wärmebehandlung durch Beibehalten bei einer Temperatur von Ar3 oder höher für zumindest 1,3t+30 Minuten, wobei t die Dicke des Stahlblechs in mm ist, und anschließend durch Ofenkühlung oder Luftkühlung umfasst.

7. Verfahren zur Fertigung eines Stahlblechs zum Abschirmen eines Magnetfeldes nach Anspruch 6, das ferner ein Spannungsarmglühen durch Wärmebehandlung bei einer Temperatur von 800 °C bis 900 °C für zumindest 1,3t+30 Minuten nach der normalisierenden Wärmebehandlung und anschließend durch Ofenkühlung umfasst.

8. Verfahren zur Fertigung eines Stahlblechs zum Abschirmen eines Magnetfeldes nach Anspruch 5, wobei während des Warmwalzens ein Vorwalzen bei einer Temperatur von Tnr bis 1250 °C vor dem Fertigwarmwalzen durchgeführt wird.

**Revendications**

1. Tôle d'acier pour blindage contre un champ magnétique, comprenant :

en % de poids, 0,02 % ou moins de carbone (C), 0,001 % à 0,05 % de silicium (Si), 0,01 % à 0,2 % de manganèse (Mn), 0,001 % ou 0,05 % d'aluminium (Al), 0,005 % ou moins de niobium (Nb), 0,07 % ou moins de titane (Ti), 0,01 % ou moins d'azote (N), 0,015 % ou moins de phosphore (P), 0,005 % ou moins de soufre (S), et le reste étant du fer (Fe) et des impuretés inévitables,

dans laquelle une microstructure a de la ferrite comme structure principale, dans laquelle la ferrite a une taille de grain moyenne de 100 $\mu$m ou plus.

2. Tôle d'acier pour blindage contre un champ magnétique selon la revendication 1, dans laquelle la tôle d'acier a une taille maximale d'un précipité, existant à une limite ou à l'intérieur du grain de ferrite, est de 100 nm ou moins.

3. Tôle d'acier pour blindage contre un champ magnétique selon la revendication 1, dans laquelle la tôle d'acier a une densité de flux magnétique de 1 T (Tesla) ou plus sous une intensité de champ magnétique de 300 A/m.

4. Tôle d'acier pour blindage contre un champ magnétique selon la revendication 1,
   dans laquelle la tôle d'acier a une limite d'élasticité de 190 MPa ou moins, une résistance à la traction de 220 MPa à 300 MPa, un allongement de 40 % ou plus et un rapport d'élasticité de 0,8 ou moins.

5. Procédé de fabrication d'une tôle d'acier pour blindage contre un champ magnétique, comprenant :

   le réchauffage d'une brame d'acier comprenant en % de poids, 0,02 % ou moins de carbone (C), 0,001 % à 0,05 % de silicium (Si), 0,01 % à 0,2 % de manganèse (Mn), 0,001 % ou 0,05 % d'aluminium (Al), 0,005 % ou moins de niobium (Nb), 0,07 % ou moins de titane (Ti), 0,01 % ou moins d'azote (N), 0,015 % ou moins de phosphore (P), 0,005 % ou moins de soufre (S), et le reste étant du fer (Fe) et des impuretés inévitables à une température de Ac3 à 1 250 °C ;
   le laminage à chaud de la brame réchauffée et le laminage à chaud de finition à une température de Ar3 ou plus pour obtenir la tôle d'acier ; et
   le refroidissement à l'air de la tôle d'acier à température ambiante, de sorte qu'une microstructure a de la ferrite comme structure principale, dans laquelle la ferrite a une taille moyenne de grain de 100 $\mu$m ou plus.

6. Procédé de fabrication d'une tôle d'acier pour blindage contre un champ magnétique selon la revendication 5, comprenant en outre la normalisation du traitement thermique de maintien à une température de Ar3 ou plus pendant au moins 1,3t + 30 minutes, où t est l'épaisseur de la tôle d'acier au moins en mm, puis, de refroidissement de four ou de refroidissement à l'air.

7. Procédé de fabrication d'une tôle d'acier pour blindage contre un champ magnétique selon la revendication 6, comprenant en outre un recuit de détente du traitement thermique à une température de 800 °C à 900 °C pendant au moins 1,3t+30 minutes après le traitement thermique de normalisation, puis, de refroidissement de four.

8. Procédé de fabrication d'une tôle d'acier pour blindage contre un champ magnétique selon la revendication 5, dans lequel, pendant le laminage à chaud, un laminage grossier est exécuté à une température de Tnr à 1 250 °C avant le laminage à chaud de finition.

[Fig. 1]

[Fig. 2]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020050129244
- JP 2013227649 A
- JP 2007016278 A
- JP 2008308704 A